# EUROPEAN PATENT APPLICATION

(11) **EP 1 921 500 A1**
(43) Date of publication of application: **14.05.2008**
(21) Application number: 06023563.7
(22) Date of filing: 13.11.2006
(51) Int. Cl.: G03F 7/031

(54) **UV-sensitive elements with triarylamine derivatives as sensitizers**

(71) Applicant: Eastman Kodak Company, Rochester, New York 14650-2201 (US)
(72) Inventor: Strehmel, Bernd, 13585 Berlin (DE); Baumann, Harald, 37520 Osterode (DE); Simpson, Christopher, 37520 Osterode (DE)
(74) Representative: Vossius & Partner

(57) **Abstract**

A UV-sensitive composition and element comprising
(a) one or more types of monomers and/or oligomers, each comprising at least one ethylenically unsaturated group accessible to a free-radical polymerization,
(b) at least one sensitizer,
(c) at least one coinitiator capable of forming free radicals together with the sensitizer (b), said coinitiator being other than metallocenes, and
(d) at least one reactive polymeric binder comprising
(i) structural units (m1) comprising at least one pendant acidic group,
(ii) structural units (m2) comprising at least one pendant free radical polymerizable group, and
(iii) optionally further structural units (m3) different from units (m1) and (m2).

The sensitizer is a substituted triarylamine of formula (I)

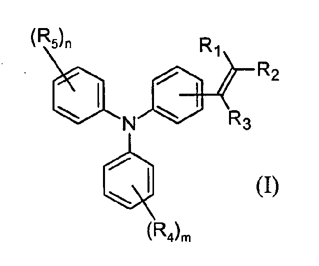

## Description

The present invention relates to negative working UV-sensitive elements like lithographic printing plate precursors whose radiation-sensitive coating comprises certain triarylamine derivatives as sensitizers in combination with a reactive binder. The invention furthermore relates to a process for the production of such elements, a process for imaging such elements and an imaged element like a printing form as well as radiation-sensitive compositions for the production of such elements.

The technique of lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. The printing ink in the image area is then transferred to the surface of a material such as paper, fabric and the like, on which the image is to be formed. Generally, the printing ink is first transferred to an intermediate material, referred to as blanket, which then in turn transfers the printing ink onto the surface of the material on which the image is to be formed; this technique is referred to as offset lithography.

A frequently used type of lithographic printing plate precursor comprises a photosensitive coating applied onto a substrate on aluminum basis. The coating can react to radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, i.e. is oleophilic, and the non-image area (background) accepts water, i.e. is hydrophilic. The differentiation between image and non-image areas takes place during exposure, for which a film is attached to the printing plate precursor under vacuum in order to guarantee good contact. The plate is then exposed by means of a radiation source. Alternatively, the plate can also be exposed digitally without a film, e.g. with a laser. When a positive plate is used, the area on the film corresponding to the image on the plate is so opaque that the light does not reach the plate, while the area on the film corresponding to the non-image area is clear and allows light to permeate the coating, whose solubility increases. In the case of a negative plate, the opposite takes place: The area on the film corresponding to the image on the plate is clear, while the non-image area is opaque. The coating beneath the clear film area is hardened due to the incident light, while the area not affected by the light is removed during developing. The light-hardened surface of a negative working plate is therefore oleophilic and accepts printing ink, while the non-image area that used to be coated with the coating removed by the developer is desensitized and therefore hydrophilic.

Photosensitive mixtures have been used for years in photopolymerizable compositions for the production of photosensitive materials such as e.g. printing plate precursors. However, an improved sensitivity in particular in the near UV and visible spectral ranges is required for new and advanced applications (e.g. exposure by means of lasers), so that the exposure time can be shortened. From an economic point of view it is of interest to use radiation sources with a reduced photon output instead of high-performance lasers since they are less expensive at the present time. Therefore, efforts have been made for some time to increase the sensitivity of photosensitive mixtures that are to be used in photopolymerizable compositions.

US-A-3,912,606 describes UV-hardenable compositions for films and coatings which in addition to ethylenically unsaturated monomers comprise a photoinitiator selected from haloalkyl benzoxazoles, benzimidazoles and benzothiazoles. In these compositions, the efficiency of the photoinitiator is insufficient. The same holds true for the radiation sensitive compositions of DE 30 121 599 A1 which comprise 2-(halomethyl-phenyl)-4-halooxazols.

EP-A-0 741 333 describes photopolymerizable compositions which in addition to ethylenically unsaturated monomers and organic binders comprise a combination of an optical brightener and a photoinitiator selected from acyl and diacyl phosphine oxides. As optical brighteners, those comprising a stilbene, triazine, thiazole, benzoxazole, coumarin, xanthene, triazole, oxazole, thiophene or pyrazoline unit are listed. However, based on today's standards, these photopolymerizable compositions do not exhibit sufficient photospeed.

US-A-3,647,467 describes "photo-activable" compositions comprising a hexaarylbiimidazole and a heterocyclic compound Ar¹-G-Ar² (wherein Ar¹ is an aryl group with 6 to 12 ring carbon atoms, Ar² is either Ar¹ or a group arylene-G-Ar¹ and G is a divalent furan, oxazole or oxadiazole ring). However, the radiation sensitivity of these compositions does not meet present-day requirements.

2-Mercaptobenzoxazoles are used as chain transfer agents in "photo-activable" compositions for example in US-A-3,652,275. However, these compounds do not function as radiation absorbers (sensitizers) in the sense of the present invention.

WO 2004/074930 A2 describes radiation-sensitive compositions comprising a 2,4,5-aryloxazole as a sensitizer. These compositions exhibit good sensitivity but resolution is insufficient for highest demands.

EP 1 349 006 A1 describes a photopolymerizable composition wherein the sensitizer is an optical brightener; this optical brightener absorbs light of a wavelength of 300 to 450 nm and exhibits fluorescence in the range of 400 to 500 nm, i.e. blue to violet fluorescent light. An improvement of the resolution would be desirable.

EP 1510 865 A2 discloses photopolymerizable compositions comprising a 1,3,5-triazine compound and a titanocene, or a trihalogenmethyl compound with a molar extinction coefficient of no more than 1,000 at laser wavelength and a titanocene. Compounds of formula below are for example used as sensitizer dye

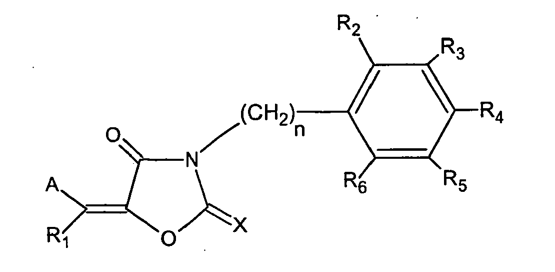

In this composition, the titanocenes are essential for good sensitivity, however, they entail a poor yellow light stability which is not desirable due to the resulting poor handling properties; such a plate requires handling under red light conditions. However, yellow light conditions are preferred in manufacturing of printing plates since red light conditions create an unpleasant working environment.

US 6,267,913 B1 and WO 02/079691 A1 describe compounds which are said to be suitable for a simultaneous 2-photon absorption. No lithographic printing plate precursors are described. Furthermore, no compounds with triarylamino groups are described.

JP 2002-221790 describes photosensitive compositions comprising a binder polymer, a titanocene and a sensitizer of the following structure:

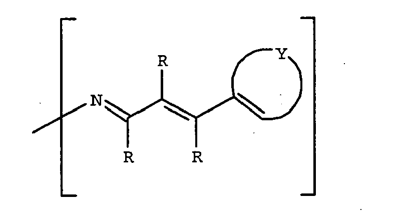

In JP 2004-301996 photosensitive resin compositions are disclosed containing a nonreactive binder polymer, a photopolymerizable compound having at least one polymerizable ethylenically unsaturated group in the molecule, a photopolymerization initiator, and at least one sensitizer of the following formulae. The use of a reactive binder was not recognized to increase the sensitivity of the radiation sensitive composition.

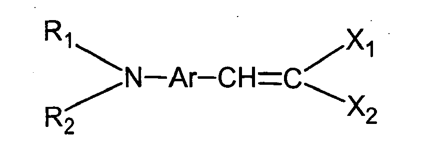

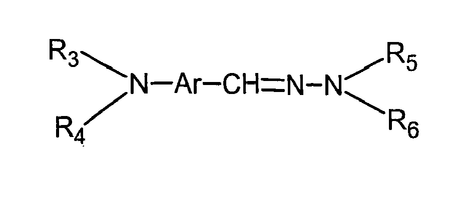

The application does not disclose reactive polymeric binders comprising free radical polymerizable groups. It would be desirable to improve the print run length of lithographic printing plates prepared according to this disclosure.

WO 01/96962 A2 and US 2001/0003032 disclose irradiation methods for broad ranges of photopolymers with short pulse lasers, resulting in polymerization initiated by two photons.

It is the object of the present invention to provide radiation-sensitive elements which show a high degree of radiation sensitivity in the range of 350 to 450 nm in combination with good storage stability and which - in case of printing plate precursors - lead to a high print run length on the printing machine; furthermore, the elements should exhibit excellent yellow light stability.

This object is achieved by an element comprising
(1) a substrate and
(2) a radiation-sensitive coating comprising
   (a) one or more types of monomers and/or oligomers, each comprising at least one ethylenically unsaturated group accessible to a free-radical polymerization,
   (b) at least one sensitizer,
   (c) at least one coinitiator capable of forming free radicals together with the sensitizer (b), said coinitiator being other than metallocenes, and
   (d) at least one reactive polymeric binder comprising
      (i) structural units (m1) comprising at least one pendant acidic group,
      (ii) structural units (m2) comprising at least one pendant free radical polymerizable group, and
      (iii) optionally further structural units (m3) different from units (m1) and (m2)
   (e) optionally one or more components selected from the group consisting of alkali-soluble non-reactive binders, colorants, exposure indicators, plasticizers, chain transfer agents, leuco dyes, surfactants, inorganic fillers and thermopolymerization inhibitors,
characterized in that the at least one sensitizer comprises a compound of formula (I) 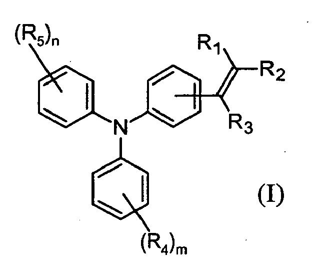 wherein
R₁ is an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₂ is selected from optionally substituted alkyl, aryl, aralkyl, alkylaryl, -N(alkyl)₂, -N(aryl)₂,-N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₃ is selected from hydrogen, optionally substituted alkyl, aryl, aralkyl, alkylaryl, -N(alkyl)₂,-N(aryl)₂, -N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₄ and R₅ are independently selected from -CR₃=CR₁R₂ with R₁, R₂ and R₃ being as defined above, optionally substituted alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -CH₂-O-R, -CH₂-S-R, -COOR and -CSOR;
if there are two adjacent substituents R₄ they can optionally form a fused aromatic or non-aromatic carbocyclic ring; the same applies to R₅;
each R is independently selected from optionally substituted alkyl, optionally substituted aryl, aralkyl and alkylaryl;
m and n are the same or different and are integers from 0 to 5.

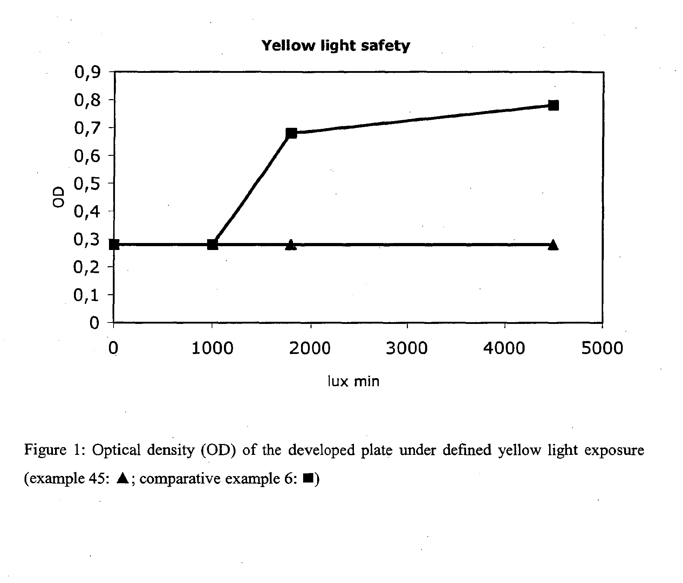

Fig. 1 illustrates the yellow light stability of the printing plate precursor of Example 45 in comparison with that of the printing plate precursor of Comparative Example 6.

Unless defined otherwise, the term "alkyl group" as used in the present invention refers to a straight-chain, branched or cyclic saturated hydrocarbon group preferably comprising 1 to 25 carbon atoms, especially preferred 1 to 18 carbon atoms and most preferred 1 to 10 carbon atoms. The alkyl group can optionally comprise one or more substituents (preferably 0 to 3 substituents) selected for example from halogen atoms (fluorine, chlorine, bromine, iodine), CN, NO₂, NR'₂, NR'₃⁺ COOR', OR' and SR' (R' independently represents a hydrogen atom, an alkyl group or an aryl group). The above definition also applies to the alkyl unit of an alkylaryl group and aralkyl group.

Unless defined otherwise, the term "aryl group" as used in the present invention refers to an aromatic carbocyclic group with one or more fused rings, which preferably comprises 5 to 14 carbon atoms. The aryl group can optionally comprise one or more substituents (preferably 0 to 3) selected for example from halogen atoms, alkyl groups, alkoxy groups, CN, NO₂, NR'₂, NR'₃⁺ COOR', OR' and SR' (wherein each R' is independently selected from hydrogen, alkyl and aryl). Preferred examples include a phenyl group and a naphthyl group which can optionally be substituted. The above definition also applies to the aryl unit of an alkylaryl group and an aralkyl group.

As used herein the term "(meth)acryl" is meant to refer to both "acryl" and "methacryl".

### Radiation-sensitive coating

### Monomers and oligomers

All monomers and oligomers which are free-radical polymerizable and comprise at least one ethylenical C-C double bond can be used as ethylenically unsaturated monomers, oligomers and polymers. Monomers/oligomers with C-C triple bonds can also be used, but they are not preferred. Suitable compounds are well known to the person skilled in the art and can be used in the present invention without any particular limitations. Esters of acrylic and methacrylic acids, itaconic acid, crotonic acid, isocrotonic acid, maleic acid and fumaric acid with one or more unsaturated groups in the form of monomers, oligomers or prepolymers are preferred. They may be present in solid or liquid form, with solid and highly viscous forms being preferred. Compounds suitable as monomers include for instance tri(methylol propane) triacrylate and trimethacrylate, pentaerythritol triacrylate and trimethacrylate, dipentaerythritolmonohydroxy pentaacrylate and pentamethacrylate, dipentaerythritol hexaacrylate and hexamethacrylate, pentaerythritol tetraacrylate and tetramethacrylate, di(trimethylol propane)tetraacrylate and tetramethacrylate, diethyleneglycol diacrylate and dimethacrylate, triethyleneglycol diacrylate and dimethacrylate or tetraethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins; within the scope of this invention oligomers/prepolymers have a weight average molecular weight (determined by gelpermeation chromatography GPC using polystyrene standards) of up to 10000 g/mol.

Free-radical polymerizable compounds that can be used in the present invention also include compounds disclosed in DE 103 56 847 A1 that have a molecular weight of 10,000 or less and are reaction products obtained by reacting a diisocyanate with (i) an ethylenically unsaturated compound with a hydroxy group, and at the same time (ii) a saturated organic compound with an NH group and an OH group, wherein the reactants are used in amounts according to the following condition:

Number of moles of isocyanate groups ≤ number of moles of OH plus NH groups.

Examples of diisocyanates are represented by the following formula:

O = C = N-(CR²⁰₂)ₐ- D -(CR²⁰₂)_{b}- N = C = O (II)

wherein a and b independently represent 0 or an integer from 1 to 3, each R²⁰ is independently selected from H and C₁-C₃ alkyl and D is a saturated or unsaturated spacer which can optionally comprise further substituents in addition to the two isocyanate groups. D can be a chain-shaped or a ring-shaped unit. As used in the present invention, the term "diisocyanate" refers to an organic compound comprising two isocyanate groups but no OH groups and secondary or primary amino groups.

R²⁰ is preferably H or CH₃.
a and b are preferably independently 0 or 1.

D can for example be an alkylene group (CH₂)_{w}, wherein w is an integer from 1 to 12, preferably 1 to 6, and one or more hydrogen atoms are optionally replaced with substituents such as e.g. alkyl groups (preferably C₁-C₆), a cycloalkylene group, an arylene group or a saturated or unsaturated heterocyclic group.

### Suitable diisocyanates are for example the following:

Trimethylhexamethylene diisocyanate
1,6-bis-[isocyanate]-hexane
5-isocyanate-3-(isocyanatomethyl)-1,1,3-trimethylcyclohexane
1,3-bis-[5-isocyanate-1,1,3-trimethyl-phenyl]-2,4-dioxo-1,3-diazetidine
3,6-bis-[9-isocyanatononyl]-4,5-di-(1-heptenyl)-cyclohexene
bis-[4-isocyanate-cyclohexyl]-methane
trans-1,4-bis-[isocyanate]-cyclohexane
1,3-bis-[isocyanatomethyl]-benzene
1,3-bis-[1-isocyanate-1-methyl-ethyl]-benzene
1,4-bis-[2-isocyanatoethyl]-cyclohexane
1,3-bis-[isocyanatomethyl]cyclohexane
1,4-bis-[1-isocyanate-1-methyl-ethyl]benzene
bis-[isocyanate]-isododecyl-benzene
1,4-bis-[isocyanate]-benzene
2,4-bis-[isocyanate]-toluene
2,6-bis-[isocyanate]-toluene
N,N'-bis-[3-isocyanate-4-methyl-phenyl] urea
1,3-bis-[3-isocyanate-4-methyl-phenyl]-2,4-dioxo-1,3-diazetidine
bis-[2-isocyanate-phenyl]-methane
(2-isocyanate-phenyl)-(4-isocyanate-phenyl)-methane
bis-[4-isocyanate-phenyl]-methane
1,5-bis-[isocyanate]-naphthalene
4,4'-bis-[isocyanate]-3,3'-dimethyl-biphenyl

The ethylenically unsaturated compound (i), which comprises a hydroxy group, comprises at least one non-aromatic C-C double bond, which is preferably terminal. The hydroxy group is preferably not bonded to a doubly bonded carbon atom; the hydroxy group is not part of a carboxy group. In addition to the one OH group, the ethylenically unsaturated compound (i) does not comprise any further functional groups, such as e.g. NH, which can react with the isocyanate.

### Examples of the ethylenically unsaturated compound (i) include

Hydroxy(C₁-C₁₂)alkyl(meth)acrylates (e.g. 2-hydroxyethyl(meth)acrylate, 2- or 3-hydroxypropyl(meth)acrylate, 2-, 3- or 4-hydroxybutyl(meth)acrylate), hydroxy(C₁-C₁₂)alkyl(meth)acrylamides (e.g. 2-hydroxyethyl(meth)acrylamide, 2- or 3-hydroxypropyl(meth)acrylamide, 2-, 3- or 4-hydroxybutyl(meth)acrylamide), mono(meth)acrylates of oligomeric or polymeric ethylene glycols or propylene glycols (e.g. polyethylene glycol mono(meth)acrylate, triethylene glycol mono(meth)acrylate), allyl alcohol, pentaerythritol tri(meth)acrylate, 4-hydroxy(C₁-C₁₂)alkyl-styrene (e.g. 4-hydroxymethylstyrene), 4-hydroxystyrene, hydroxycyclohexyl(meth)acrylate.

The term "(meth)acrylate" etc. as used in the present invention indicates that both methacrylate and acrylate etc. are meant.

The saturated organic compound (ii) is a compound with one OH and one NH group.

The saturated organic compound (ii) can for example be represented by the following formula (III) or (IV) 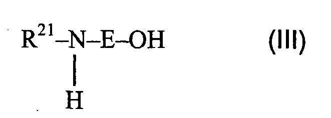 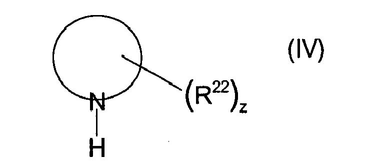 wherein R²¹ is a straight-chain (preferably C₁-C₁₂, especially preferred C₁-C₄), branched (preferably C₃-C₁₂, especially preferred C₃-C₆) or cyclic (preferably C₃-C₈, especially preferred C₅-C₆) alkyl group,
E is a straight-chain (preferably C₁-C₆, especially preferred C₁-C₂), branched (preferably C₃-C₁₂, especially preferred C₃-C₆) or cyclic (preferably C₃-C₈, especially preferred C₅-C₆) alkylene group, 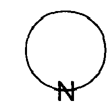 represents a saturated heterocyclic ring with 5 to 7 ring atoms, which in addition to the nitrogen atom shown above optionally comprises another heteroatom selected from S, O and NR²³, wherein R²³ is an alkyl group optionally substituted with an OH group, R²² is OH or a straight-chain, branched or cyclic alkyl group substituted with an OH group, and z = 0 if the heterocyclic ring comprises NR²³ and R²³ is an alkyl group substituted with OH and z = 1 if the saturated heterocyclic ring does not comprise NR²³ or if the saturated heterocyclic ring comprises NR²³ and R²³ is an unsubstituted alkyl group.

Of the compounds of formula (III), those are preferred wherein E represents -CH₂CH₂- and R²¹ is a straight-chain C₁-C₁₂ (preferably C₁-C₄) alkyl group.

Of the compounds of formula (IV), those are preferred wherein either no additional heteroatom is present in the ring and R²² is an alkyl group substituted with OH (i.e. hydroxyalkyl-substituted piperidines), or a group NR²³ is present in the ring and R²³ is an alkyl group substituted with OH (i.e. N-hydroxyalkyl-substituted piperazines).

In particular, the following compounds should be mentioned as compound (ii):
2- or 3-(2-hydroxyethyl)piperidine,
2- or 3-hydroxymethylpiperidine,
N-(2-hydroxyethyl)piperazine and
N-(2-hydroxymethyl)piperazine.

The number of moles of isocyanate groups must not exceed the number of moles of OH groups and NH groups combined since the product should not comprise any more free isocyanate groups.

The reaction of the diisocyanate and the ethylenically unsaturated compound (i) and the saturated compound (ii) usually takes place in an aprotic solvent such as a ketone (e.g. acetone, methyl ethyl ketone, diethyl ketone, cyclopentanone and cyclohexanone), an ether (e.g. diethyl ether, diisopropyl ether, tetrahydrofuran, dioxane and 1,2-dioxolane) and an ester (e.g. ethyl acetate, methyl acetate, butyl acetate, ethylene glycol diacetate, methyl lactate and ethyl lactate) or in a technical solvent such as ethylene glycol monomethyl ether acetate, propylene glycol monomethyl ether acetate etc.

It is preferred to use a catalyst for condensation reactions. All known catalysts suitable for condensation reactions can be used. Examples include tertiary amines, such as triethylamine, pyridine etc. and tin compounds, such as dibutyltin dilaurate.

The reaction preferably takes place at 10 to 120°C, especially preferred at 30 to 70°C.

Under optimized synthesis conditions a uniform product can be obtained. However, as a rule it has to be assumed that a mixed product is formed. The molecular weight of the product should be 3,000 or less. In the case of a mixed product, the molecular weight is the weight-average molecular weight. Both a uniform reaction product and a mixed product can be used as a free-radical polymerizable compound in the present invention.

Additional suitable C-C unsaturated free-radical polymerizable compounds are described e.g. in EP-A-1 176 007.

Another group of suitable unsaturated oligomers is represented by Formula (V): 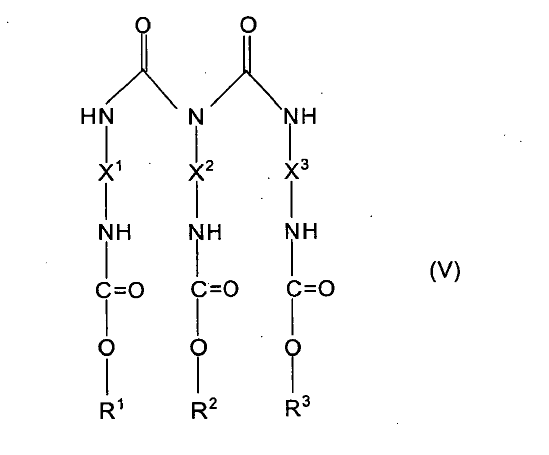 wherein X¹, X² and X³ are independently selected from straight-chain or cyclic C₄ - C₁₂ alkylene and C₆ - C₁₀ arylene, a heterocyclic group, a heteroaromatic group and combinations of two or more of the above,
R¹, R² and R³ are independently selected from

-(CHR⁴-CHR⁴-O)ₙ-R⁵ (VI)

and 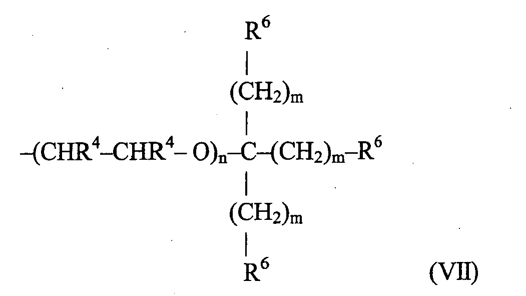 wherein
each R⁴ is independently selected from a hydrogen atom and CH₃, each n is independently 0 or an integer from 1 to 20, each m is independently 0 or 1;
if n in formula (VI) is 0, R⁵ is independently selected from

- CH = CH₂ , - CH₂ - CH = CH₂ and

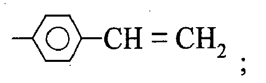

if n in formula (VI) is an integer from 1 to 20, R⁵ is independently selected from 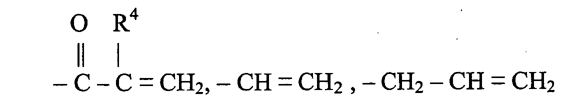 and 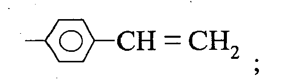 and each R⁶ is independently selected from a hydrogen atom, 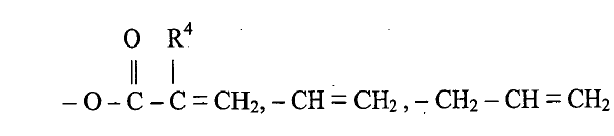 and 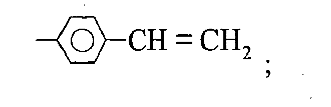 with the proviso that (1) n = 0 in at least one of the groups R¹, R² and R³, and (2) n > 2 in at least one of the groups R¹, R² and R³, and (3) at least one group R⁶ is different from H in formula (VII).

In formula (VI), n is preferably > 2; especially preferred, n ≥ 6.

In formula (VII), n is preferably 0 and m is preferably 0 or 1.

R⁶ is preferably 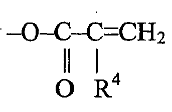 or H, with the proviso that at least one R⁶ is different from H.

It is preferred that the at least one group of R¹, R² and R³ wherein n > 2 is represented by formula (VI).

It is preferred that in the spacer -(CHR⁴-CHR⁴-O)- either both groups R⁴ represent hydrogen, or that one represent hydrogen and the other CH₃. The spacer -(CHR⁴-CHR⁴-O)ₙ- can for example be polyethylene glycol units, polypropylene glycol units or a block copolymer unit with one or more polypropylene glycol blocks and one or more polyethylene glycol blocks.

According to one embodiment, two of the groups R¹, R² and R³ are glycerin-1,3-di(meth)acrylate groups and the third a polyethylene glycol(meth)acrylate group or a polypropylene glycol(meth)acrylate group (each with n > 2, preferably n ≥ 6).

The oligomer A of formula (V) can be prepared as follows:
In a first step, the basic biuret structure is prepared by reacting at least one diisocyanate of the formula

   O=C=N-X-N=C=O

   (wherein X is defined as are X¹, X² and X³) and an appropriately selected amount of water, usually 3 moles diisocyanate(s) and 1 mole water (see also e.g. DE-B-1,101,394 and Houben-Weyl, Methoden der organischen Chemie [methods in organic chemistry], 4th edition (1963), Vol. 14/2, pages 69 et seqq.). The reaction is preferably carried out without a solvent. In a second step, the terminal isocyanate groups are reacted with at least two different unsaturated compounds of the following formula comprising one or more hydroxy groups

   HO-(CHR⁴-CHR⁴-O)ₙ-R⁵ (VIa)

   and/or 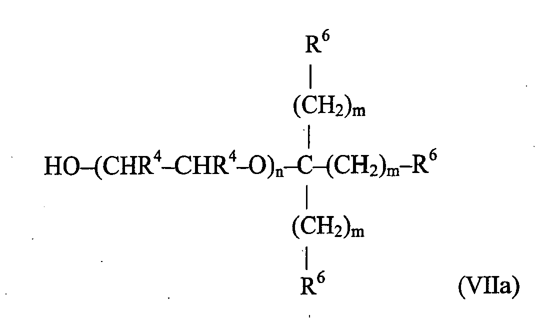 (wherein R⁴, R⁵, R⁶, n and m are as defined above) so that a compound of formula (I) is obtained wherein n = 0 in at least one of groups R¹, R² and R³ and n > 2 in at least one of them.

Further suitable free-radical polymerizable oligomers are oligomers A which have an average molecular weight of 3,500 to 9,000 determined by gel-permeation chromatography (GPC), and are prepared by reacting a triisocyanate, preferably a triisocyanate of the formula (VIII), (IX) or (X-1) to (X-7) shown below, with (i) at least one (meth)acrylic monomer with two free OH groups and (ii) at least one (meth)acrylic compound with one free OH group and a poly(alkyleneoxide) chain, and optionally (iii) at least one (meth)acrylic monomer with one free OH group but no poly(alkyleneoxide) chain; the amount of (meth)acrylic monomer (i) is 2 to 20 mole-%, based on the total amount of (meth)acrylic compounds with OH functionality. The terminal isocyanate groups are reacted with the free OH groups of the (meth)acrylic compounds.

Details regarding the preparation of the oligomers A can e.g. be inferred from DE-A-2,361,041. Possibly present unreacted isocyanate groups are quenched by reaction with an alcohol.

The triisocyanates of formula (VIII) have a biuret structure 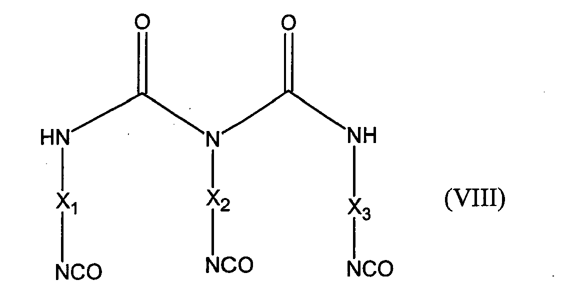 wherein X₁, X₂ and X₃ are independently selected from aliphatic or cycloaliphatic C₄-C₁₂ spacers, araliphatic C₈-C₁₂ spacers and aromatic C₆-C₁₀ spacers, preferably aliphatic and cycloaliphatic C₄-C₁₂-Spacern; preferably X₁ = X₂ = X₃ = hexamethylene.

The triisocyanates of formula (IX) have a cyanuric acid core 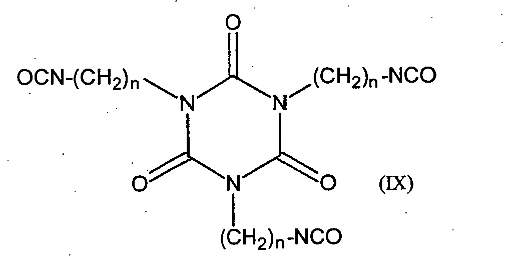 wherein each n is independently an integer from 1 to 10, preferably 2 to 8, and especially preferred 6; preferably, all variables n in formula (IX) are the same.

The triisocyanates (X) are aromatic or aliphatic triisocyanates of formulas (X-1) to (X-7)

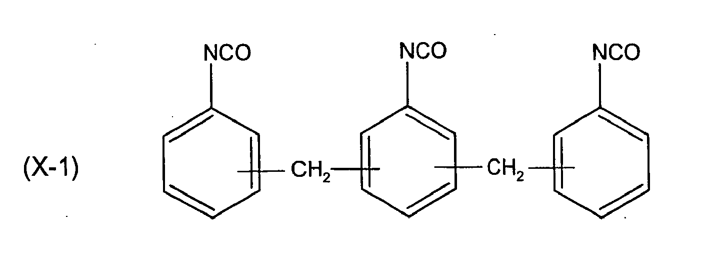

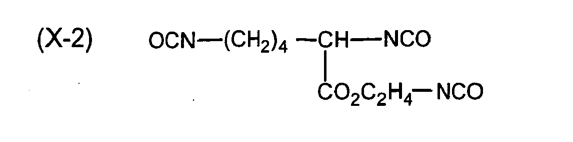

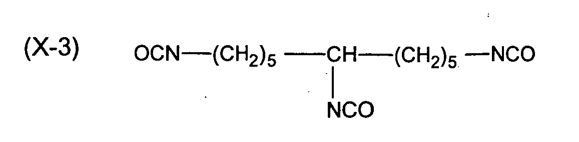

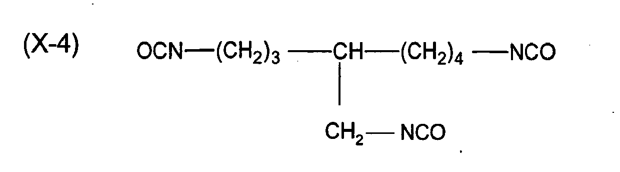

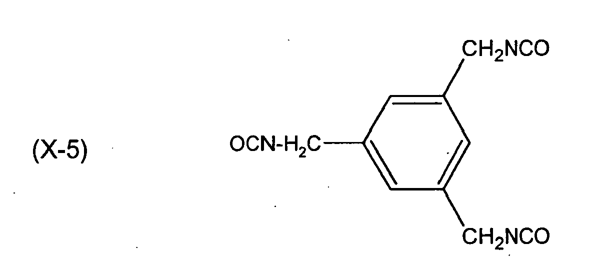

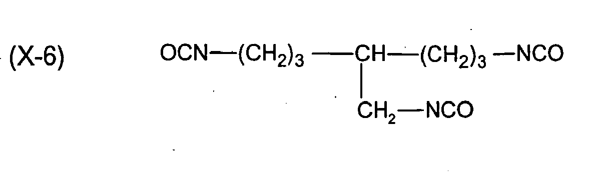

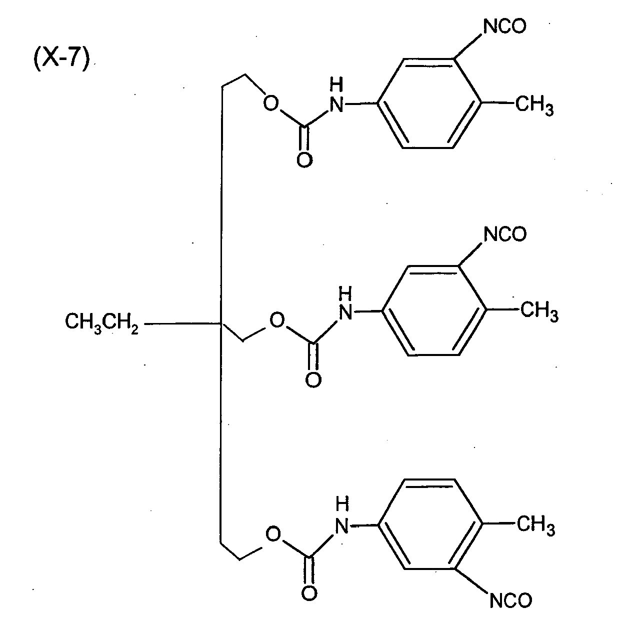

All partial esters of trivalent or polyhydric alcohols with acrylic acid or methacrylic acid which still have two free OH groups can for example be used as (meth)acrylic monomers (i) with two OH groups and at least one (meth)acrylic group.

Suitable examples include pentaerythritol di(meth)acrylate, glycerin mono(meth)acrylate, trimethylolpropane mono(meth)acrylate, trimethylolethane mono(meth)acrylate, trimethylolbutane mono(meth)acrylate, sorbitol tetra(meth)acrylate, reaction product of bisphenol-A-diglycidylether and (meth)acrylic acid.

Partial esters of divalent or polyhydric alcohols with poly(alkyleneoxide) chains and (meth)acrylic acid which still have one free OH group can for example be used as (meth)acrylic compounds (ii) with one OH group and poly(alkyleneoxide) chains. The poly(alkyleneoxide) chains are preferably C₂-C alkyleneoxide chains, especially preferred polyethyleneoxide and polypropyleneoxide chains with a degree of polymerization of at least 3. Suitable examples include poly(ethyleneoxide) mono(meth)acrylate, poly(propyleneoxide) mono(meth)acrylate, statistical copolymers or block copolymers of propyleneoxide and ethyleneoxide, esterified with (meth)acrylic acid at one end, ethoxylated and/or propoxylated glycerin, doubly esterified with (meth)acrylic acid.

All partial esters of divalent or polyhydric alcohols with acrylic acid or methacrylic acid which still have one free OH group can for example be used as optional (meth)acrylic monomers (iii) without poly(alkyleneoxide) chains with at least one (meth)acrylic group and only one OH group.

Suitable examples include pentaerythritol tri(meth)acrylate, glycerin di(meth)acrylate, trimethylolpropane di(meth)acrylate, trimethylolethane di(meth)acrylate, trimethylolbutane di(meth)acrylate, trimethylolbutane di(meth)acrylate, sorbitol penta(meth)acrylate.

Ethoxylated and/or propoxylated glycerin mono-esterified with (meth)acrylic acid can optionally be used as well.

For cost reasons, the use of a technical mixture of (meth)acrylates as component (i) can be considered; examples thereof include
- glycerin di(meth)acrylate comprising up to 15 wt.-% glycerin mono(meth)acrylate and furthermore up to 40 wt.-% glycerin tri(meth)acrylate;
- trimethylolpropane di(meth)acrylate, comprising up to 15 wt.-% trimethylolpropane mono(meth)acrylate and furthermore up to 40 wt.-% trimethylolpropane tri(meth)acrylate;
- pentaerythritol tri(meth)acrylate, comprising up to 15 wt.-% pentaerythritol di(meth)acrylate and furthermore up to 40 wt.-% pentaerythritol tetra(meth)acrylate.

It is of course possible to use different kinds of monomers, oligomers or polymers in the mixture; furthermore, mixtures of monomers and oligomers and/or polymers can be used in the present invention, as well as mixtures of oligomers and polymers. The free-radical polymerizable monomers/oligomers/polymers are preferably present in an amount of 5 to 95 wt.-%; if monomers/oligomers are used, especially preferred 20 to 85 wt.-%, based on the dry layer weight of a radiation-sensitive coating prepared from the radiation-sensitive composition of the present invention. As used in the present invention, the term "dry layer weight of the radiation-sensitive coating" is therefore synonymous with the term "solids of the radiation-sensitive composition".

### Binders

Suitable binders are "reactive binders", i.e. polymeric binders having side chains comprising free radical polymerizable groups.

Since the binder should be soluble in aqueous alkaline developers suitable binders also comprise side chains comprising acidic groups.

The polymer backbone is not particularly limited and can for instance be selected from an acrylic backbone, methacrylic backbone, acetal backbone, urethane backbone, polyester backbone, poly(alkylene oxide) backbone (preferred polyalkylene oxides are polyethylene oxides and polypropylene oxides as well as random or block copolymers thereof), cellulose backbone and styrene backbone; copolymers of the aforementioned are also possible.

Suitable free radical polymerizable groups in the side chain are, for example, acryl groups, methacryl groups, styryl groups, allyl groups, acrylamide groups, methacrylamide groups, maleimide groups, maleate groups, fumarate groups, vinyl ester groups, itaconate groups, and mixtures of two or more thereof. Deteiled information on free radical polymerizable groups is found in "Handbook of Radical Polymerization" from K. Matyaszewski and T.P. Davis, Wiley-Interscience, New York 2002. The polymerizable groups can be directly bonded to the polymer backbone or via a spacer group.
Suitable acidic groups in the side chains are for instance -COOH, -SO₃H, -SO₂H, -PO₃H₂,-PO₄H₂, aromatic OH, and acidic amide (including acidic sulphonamide groups) or imide groups. The acidic groups can be directly bonded to the polymer backbone or via a spacer group.

It is also within the scope of the present invention that the acidic group and the free radical polymerizable group are in the same side chain.

Besides the essential structural units (m1) with pendant acidic groups and structural units (m2) with pendant free radical polymerizable groups the binder polymers can optionally comprise further structural units (m3) different from (m1) and (m2). Structural units (m3) may for instance be selected from hydrophilic units like units derived from acrylamides, methacrylamides, N-alkyl(meth)acrylamides, sulfobetaines, hydroxyalkyl(meth)acrylates, poly(alkylene oxides), and polyalkylene glycol (meth)acrylates, hydrophobic units like units derived from styrene, alkyl (meth)acrylates and alkenes, or a mixture of hydrophilic and hydrophobic units.

Preferred structural units (m3) are derived from alkyl (meth)acrylates, wherein the alkyl moiety is optionally substituted with one or more halogen atoms, (meth)acrylamide, styrene, N-alkyl(meth)acrylamide, polypropylene glycole (meth)acrylate, and polyethylene glycol (meth)acrylate.

The reactive binders used in the present invention preferably have a weight average molecular weight of at least 20000 g/mol, more preferably at least 50000 g/mol, determined by GPC using polystyrene standards.

Reactive binders are disclosed in a number of patent applications e.g. WO 2004/014652 A1, WO 89/06659 A1, DE 2 903 270 A1, WO 95/12147, EP 0 410 242 and US 4,035,321.

It is also within the scope of the present invention that mixtures of two or more reactive binders are used.

The reactive binders preferably have an acid number in the range of 20 to 180 mg KOH/g polymer, more preferably from 20 to 120 mg KOH/g polymer, wherein the acid number denotes the amount of KOH in mg necessary for neutralizing 1g of polymer and is determined by titration.

The total amount of reactive binders is preferably 5 to 95 wt.% based on the dry layer weight, especially preferred 10 to 85 wt.%.

A sensitizer as referred to in the present invention is a compound which can absorb radiation when it is exposed but which cannot by itself, i.e. without the addition of coinitiators, form free radicals.

In the present invention, one sensitizer or a mixture of two or more can be used.

According to the present invention, the sensitizer comprises a compound of formula (I): 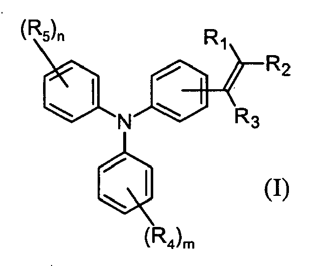 wherein
R₁ is an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₂ is selected from optionally substituted alkyl, aryl, aralkyl, alkylaryl, -N(alkyl)₂, -N(aryl)₂,-N(alkyl)(aryl), -O-alkyl, -S-alkyl, -O-aryl, -S-aryl, -O-acyl, -S-acyl, halogen, cyano, substituted boron, -COOR,
-CSOR, and an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -0-acyl, -S-acyl, halogen, cyano, substituted boron, -COOR and -CSOR;
R₃ is selected from hydrogen, optionally substituted alkyl, aryl, aralkyl, alkylaryl, -N(alkyl)₂,-N(aryl)₂, -N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₄ and R₅ are independently selected from -CR₃=CR₁R₂ with R₁, R₂ and R₃ being as defined above, optionally substituted alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -CH₂-O-R, -CH₂-S-R, -COOR and -CSOR;
if there are two adjacent substituents R₄ they can optionally form a fused aromatic or non-aromatic carbocyclic ring; the same applies to R₅;
each R is independently selected from optionally substituted alkyl, optionally substituted aryl, aralkyl and alkylaryl;
m and n are the same or different and are integers from 0 to 5.
R₁ is preferably selected from phenyl and substituted phenyls.
R₂ is preferably selected from optionally substituted aryl, optionally substituted alkyl, halogen and cyano, more preferably optionally substituted phenyl.
It is preferred that R₃ is selected from optionally substituted aryl, optionally substituted alkyl, and hydrogen, more preferably it is hydrogen.
Preferably R₄ and R₅ are independently selected from optionally substituted aryl, more preferably optionally substituted phenyl. If two adjacent substituents R₄ and/or R₅ form a fused aromatic or non-aromatic carbocyclic ring said carbocyclic ring is preferably a 5- or 6-membered ring.
Preferably m and n are independently selected from 0 and 1.

If m and/or n is 1, the substituent R₄ and R₅, respectively are preferably bonded to the phenyl ring in p-position relative to the N bonding site.

The following compounds of formula (I) are especially preferred:

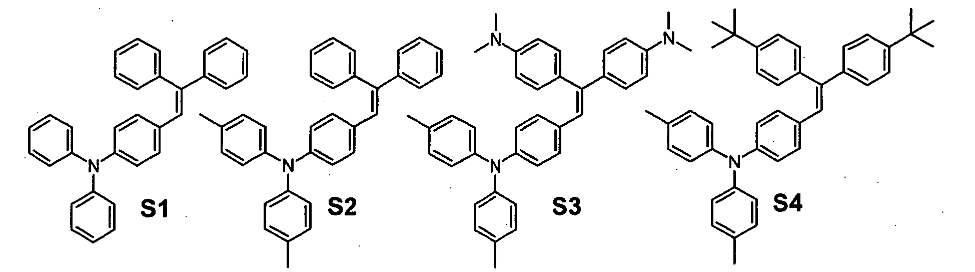

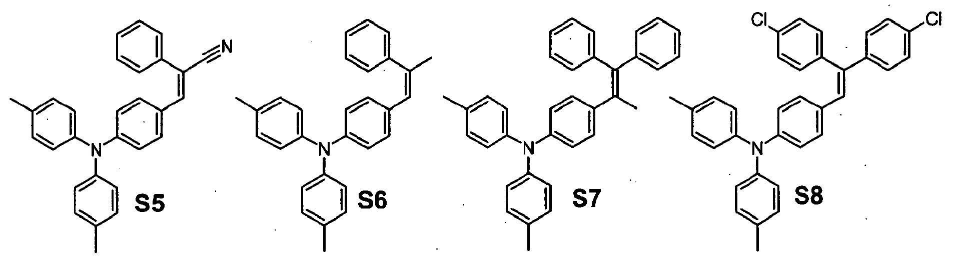

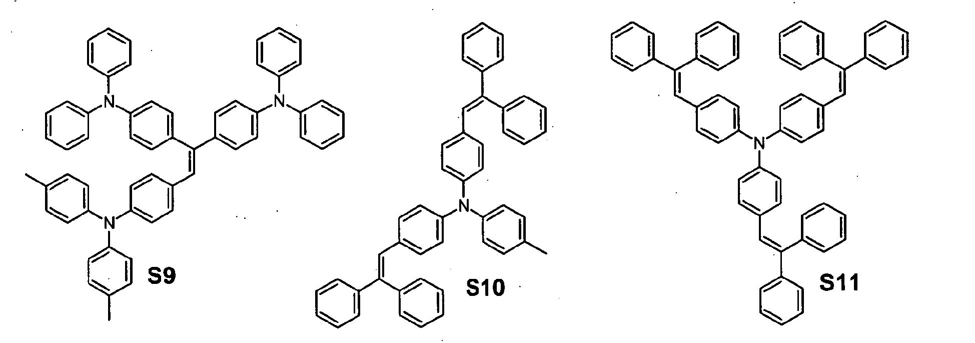

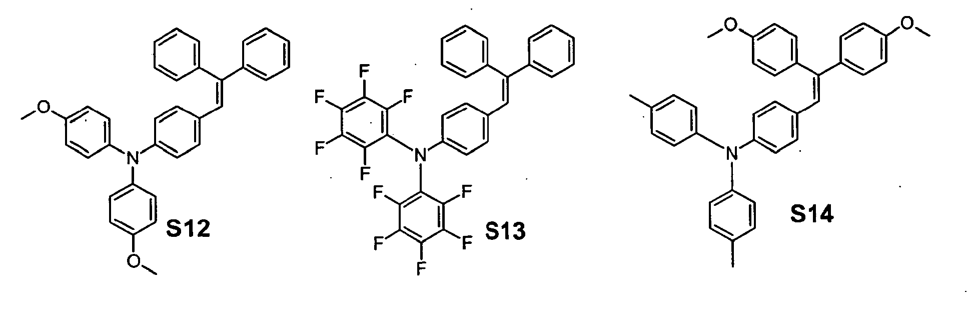

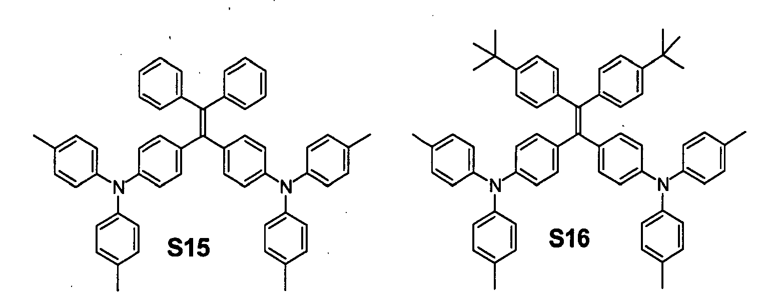

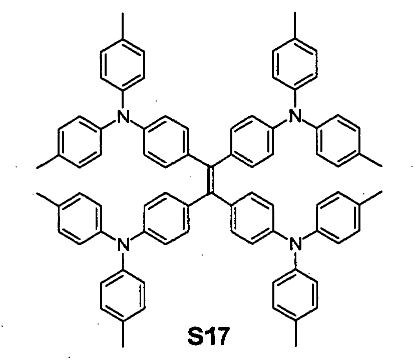

The compounds of formula (I) used in the present invention are also suitable for simultaneous two-photon excitation which can lead to an improvement of the resolution of the radiation-sensitive coatings. Theoretical discussions of the phenomenon of two-photon excitation can for example be found in Ann. Phys. 1931, 273 (M. Göppert-Mayer), Acc. Chem. Res. 1984, 17, 250 (L. Goodman, R.P. Rava) and Rep. Prog. Phys. 1997, 59, 1041 (J.D. Bhawalkar, G.S. He, P.N. Prasad).

The compounds of formula (I) used in the present invention can be prepared using processes known to the person skilled in the art, for example by a coupling reaction resulting in a triphenylamine with attached olefinic group. In this connection reference can be made to

M. John Plater and Toby Jackson, "Polyaromatic amines. Part 3: Synthesis of poly(diarylamino)styrenes and related compounds", Tetrahedron 59 (2003) 4673-4685 and Mecheril V. Nandakumar and John G. Verkade, "One-Pot Sequential N and C Arylations : An Efficient Methodology for the Synthesis of trans 4-N,N'-Diaryl Aminostilbenes", Angewandte Chemie 2005, 117, 3175 -3178.

The processes described therein can also be used for the synthesis of compounds not explicitly disclosed therein by varying the starting compounds accordingly.

It is possible to use one sensitizer of formula (I) or a mixture of two or more sensitizers of formula (I).

The amount of sensitizer(s) of formula (I) is not particularly restricted; however, it is preferably in the range of 0.2 to 25 wt.-%, based on the solids content of the coating solution or the dry layer weight of a coating produced from the composition, especially preferred are 0.5 to 15 wt.-%.

If desired, one or more other sensitizers can be used in addition to the sensitizers according to the present invention as long as they are not incompatible with the solution of the technical problem. Their amount is preferably within the range of 0 to 5 wt% based on the dry layer weight, in any case less then the amount of sensitizer(s) of formula (I).

### Coinitiators

A coinitiator as referred to in the present invention is a compound that is essentially unable to absorb when irradiated but forms free radicals together with the radiation-absorbing sensitizers used in the present invention; metallocenes are not used as coinitiators in the present invention as they have a negative effect on the yellow light stability of the element. The coinitiators can for example be selected from onium compounds, for example those where the onium cation is selected from iodonium, sulfonium, phosphonium, oxylsulfoxonium, oxysulfonium, sulfoxonium, ammonium, diazonium, selenonium, arsenonium and N-substituted N-heterocyclic onium cations wherein N is substituted with an optionally substituted alkyl, alkenyl, alkinyl or aryl (e.g. N-alkoxypyridinium salts); N-arylglycines and derivatives thereof (e.g. N-phenylglycine); aromatic sulfonyl halides; trihalomethylsulfones; imides such as N-benzoyloxyphthalimide; diazosulfonates; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof and other coinitiators described in US-A-5,629,354); hexaarylbiimidazoles; thiol compounds (e.g. mercaptobenzthiazoles, mercaptooxadiazoles, mercaptotetrazines, mercaptoimidazoles, mercaptotetrazoles, mercaptopyridines, mercaptooxazoles and mercaptotriazoles; they include 2-mercaptobenzoxazole, 2-mercaptobenzothiazole, 2-mercaptobenzimidazole, pentaerythritol-tetrakis(mercaptoacetate), 4-acetamidothiophenol, mercaptosuccinic acid, dodecanthiol, betamercaptoethanol, 6-ethoxy-2-mercaptobenzothiazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzene thiol, 1-phenyl-1H-tetrazole-5-thiol, 4-phenyl-4H-1,2,4-triazole-3-thiol, pentaerythritol-tetrakis(3-mercaptopropionate), trimethylolpropane-tris(mercaptoacetate), 2-mercaptopyridine, 4-mercaptopyridine, 2-mercapto-3H-quinazoline and 2-mercaptothiazoline); 1,3,5-triazine derivatives with 1 to 3 CX₃ groups (wherein every X is independently selected from a chlorine or bromine atom, and is preferably a chlorine atom), such as e.g. 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bistrichloromethyl-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; oxime ethers and oxime esters, such as for example those derived from benzoin; α-hydroxy or α-amino acetophenones; mono-, di- and triacylphosphine oxides, and peroxides (e.g. those listed in EP-A1-1 035 435 as activators of the type of an organic peroxide).

Hexaarylbiimidazoles, onium compounds and thiol compounds as well as mixtures of two or more thereof are preferred coinitiators; especially preferred are hexaarylbiimidazoles and mixtures thereof with thiol compounds.

Suitable hexaarylbiimidazoles are for example represented by the following formula (XI): 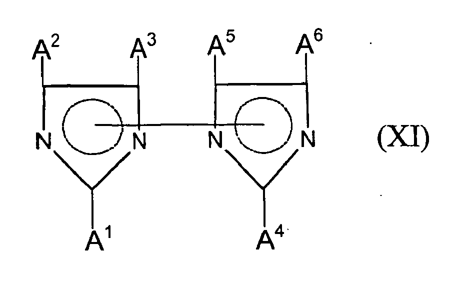 wherein A¹-A⁶ are substituted or unsubstituted C₅-C₂₀ aryl groups which are identical or different from each other and in whose rings one or more carbon atoms can optionally be substituted by heteroatoms selected from O, N and S. Suitable substituents for the aryl groups are those that do not inhibit the light-induced dissociation to triarylimidazolyl radicals, e.g. halogen atoms (fluorine, chlorine, bromine, iodine), -CN, C₁-C₆ alkyl (optionally with one or more substituents selected from halogen atoms, -CN and -OH), C₁-C₆ alkoxy, C₁-C₆ alkylthio, (C₁-C₆ alkyl) sulfonyl.

Preferred aryl groups are substituted and unsubstituted phenyl, biphenyl, naphthyl, pyridyl, furyl and thienyl groups. Especially preferred are substituted and unsubstituted phenyl groups, and particularly preferred are halogen-substituted phenyl groups.

### Examples include:

2,2'-bis(bromophenyl)-4,4',5,5'-tetraphenylbiimidazole,
2,2'-bis(p-carboxyphenyl)-4,4',5,5"-tetraphenylbiimidazole,
2,2'-bis(o-chlorophenyl)-4,4',5,5'-tetrakis(p-methoxyphenyl)biimidazole,
2,2'-bis(p-chlorophenyl)-4,4',5,5'-tetrakis(p-methoxyphenyl)biimidazole,
2,2'-bis(p-cyanophenyl)-4,4' 5,5'-tetrakis(p-methoxyphenyl)biimidazole,
2,2'-bis(2,4-dichlorophenyl)-4,4',5,5'-tetraphenylbiimidazole,
2,2'-bis(2,4-dimethoxyphenyl)-4,4',5,5'-tetraphenylbiimidazole,
2,2'-bis(o-ethoxyphenyl)-4,4',5,5'-tetraphenylbiimidazole,
2,2'-bis(m-fluorophenyl)-4,4',5,5'-tetraphenylbiimidazole,
2,2'-bis(o-fluorophenyl)-4,4',5,5'-tetraphenylbiimidazole,
2,2'-bis(p-fluorophenyl)-4,4',5,5'-tetraphenylbiimidazole,
2,2'-bis(o-hexoxyphenyl)-4,4',5,5'-tetraphenylbiimidazole,
2,2'-bis(o-hexylphenyl)-4,4',5,5'-tetrakis(p-methoxyphenyl)biimidazole,
2,2'-bis(3,4-methylenedioxyphenyl)-4,4',5,5'-tetraphenylbiimidazole,
2,2'-bis(o-chlorophenyl)-4,4',5,5'-tetrakis(m-methoxyphenyl)biimidazole,
2,2'-bis(o-chlorophenyl)-4,4',5,5'-tetrakis[m-(betaphenoxy-ethoxyphenyl)]biimidazole,
2,2'-bis(2,6-dichlorophenyl)-4,4',5,5'-tetraphenylbiimidazole,
2,2'-bis(o-methoxyphenyl)-4,4',5,5'-tetraphenylbiimidazole,
2,2'-bis(p-methoxyphenyl)-4,4'-bis(o-methoxyphenyl)-5,5'-diphenylbiimidazole,
2,2'-bis(o-nitrophenyl)-4,4',5,5'-tetraphenylbiimidazole,
2,2'-bis(p-phenylsulfonylphenyl)-4,4',5,5'-tetraphenylbiimidazole,
2,2'-bis(p-sulfamoylphenyl)-4,4',5,5'-tetraphenylbiimidazole,
2,2'-bis(2,4,5-trimethylphenyl)-4,4',5,5'-tetraphenylbiimidazole,
2,2'-di-4-biphenylyl-4,4',5,5'-tetraphenylbiimidazole,
2,2'-di-1-naphthyl-4,4',5,5'-tetrakis(p-methoxyphenyl)biimidazole,
2,2'-di-9-phenanthryl-4,4',5,5'-tetrakis(p-methoxyphenyl)biimidazole,
2,2'-diphenyl-4,4',5,5'-tetra-4-biphenylylbiimidazole,
2,2'-diphenyl-4,4',5,5'-tetra-2,4-xylylbiimidazole,
2,2'-di-3-pyridyl-4,4',5,5'-tetraphenylbiimidazole,
2,2'-di-3-thienyl-4,4',5,5'-tetraphenylbiimidazole,
2,2'-di-o-tolyl-4,4',5,5'-tetraphenylbiimidazole,
2,2'-di-p-tolyl-4,4'-di-o-tolyl-5,5'-diphenylbiimidazole,
2,2'-di-2,4-xylyl-4,4',5,5'-tetraphenylbiimidazole,
2,2',4,4',5,5'-hexakis(p-phenylthiophenyl)biimidazole,
2,2',4,4',5,5'-hexa-1-naphthylbiimidazole,
2,2',4,4',5,5'-hexaphenylbiimidazole,
2,2'-bis(2-nitro-5-methoxyphenyl)-4,4',5,5'-tetraphenylbiimidazole,
2,2'-bis(o-nitrophenyl)-4,4',5,5'-tetrakis(m-methoxyphenyl)biimidazole,
2,2'-bis(2-chloro-5-sulfophenyl)-4,4',5,5'-tetraphenylbiimidazole,
2,2',5-tris(2-chlorphenyl)-4-(3,4-dimethoxyphenyl)-4,5'diphenylbiimidazole,
2,2'-bis(o-chlorophenyl)-4,4',5,5'-tetraphenylbiimidazole,
2,2'-bis(o-chlorophenyl)-4,4',5,5'-tetra(p-fluorophenyl)biimidazole,
2,2'-bis(o-bromophenyl)-4,4',5,5'-tetra(p-iodophenyl)biimidazole,
2,2'-bis(o-chlorophenyl)-4,4',5,5'-tetra(p-chloronaphthyl)biimidazole,
2,2'-bis(o-chlorophenyl)-4,4',5,5'-tetra(p-chlorophenyl)biimidazole,
2,2'-bis(o-bromophenyl)-4,4',5,5'-tetra(p-chloro-p-methoxyphenyl)biimidazole,
2,2'-bis(o-chlorophenyl)-4,4',5,5'-tetra(o,p-dichlorophenyl)biimidazole,
2,2'-bis(o-chlorophenyl)-4,4',5,5'-tetra(o,p-dibromophenyl)biimidazole,
2,2'-bis(o-bromophenyl)-4,4',5,5'-tetra(o,p-dichlorophenyl)biimidazole or
2,2'-bis(o,p-dichlorophenyl)-4,4',5,5'-tetra(o,p-dichlorophenyl)biimidazole.

Suitable hexaarylbiimidazoles are for example described in US-A-4,565,769 and US-A-3,445,232 and can be prepared according to known methods, such as e.g. the oxidative dimerization of triarylimidazoles.

In the present invention, one coinitiator or a mixture of coinitiators can be used. Metallocenes are not suitable as coinitiators of the present invention since it has been found that they *inter alia* affect the yellow light stability.

The amount of coinitiator(s) is not particularly restricted; however, it is preferably in the range of 0.2 to 25 wt.-%, based on the dry layer weight, especially preferred 0.5 to 15 wt.-%.

### Optional additives

The radiation-sensitive coating can optionally comprise non-reactive binders, i.e. polymers without free radical polymerizable groups. Examples are for instance phenolic resins like novolacs and resols and copolymers of (meth)acrylic acid and alkyl (meth)acrylate. If non-reactive binders are present their amount is not more than 50 wt.-% based on the total amount of reactive and non-reactive binders; more preferably their amount is 0 - 20 wt.-% based on the total amount of reactive and non-reactive binders.

The radiation-sensitive coating can optionally comprise small amounts of a thermopolymerization inhibitors. Suitable examples of such inhibitors to prevent an undesired thermopolymerization include e.g. hydroquinone, p-methoxyphenol, di-t-butyl-p-cresol, pyrrogallol, t-butylcatechol, benzoquinone, 4,4'-thio-bis-(3-methyl-6-t-butylphenol), 2,2'-methylene-bis-(4-methyl-6-t-butylphenol) and N-nitrosophenylhydroxylamine salts. The amount of non-absorbing polymerization inhibitor in the radiation-sensitive coating is preferably 0 to 5 wt.-%, based on the dry layer weight, especially preferred 0.01 to 2 wt.-%. Such inhibitors are often introduced into the radiation-sensitive coating via commercial monomers or oligomers and are therefore not expressly mentioned.

Furthermore, the radiation-sensitive coating of the present invention can comprise dyes or pigments for coloring the layer (contrast dyes and pigments). Examples of colorants include e.g. phthalocyanine pigments, azo pigments, carbon black and titanium dioxide, triarylmethane dyes, such as ethyl violet and crystal violet, azo dyes, anthraquinone dyes and cyanine dyes. The amount of colorant is preferably 0 to 20 wt.-%, based on the dry layer weight, especially preferred 0.5 to 10 wt.-%.

For improving the physical properties of the hardened layer, the radiation-sensitive coating can additionally comprise further additives such as plasticizers or inorganic fillers. Suitable plasticizers include e.g. dibutyl phthalate, dioctyl phthalate, didodecyl phthalate, dioctyl adipate, dibutyl sebacate, triacetyl glycerin and tricresyl phosphate. The amount of plasticizer is not particularly restricted, however, it is preferably 0 to 10 wt.-%, based on the dry layer weight, especially preferred 0.25 to 5 wt.-%. Suitable inorganic fillers include for example Al₂O₃ and SiO₂; they are preferably present in an amount of 0 to 20 wt.-%, based on the dry layer weight, especially preferred 0.1 to 5 wt.-%.

The radiation-sensitive coating can also comprise known chain transfer agents. They are preferably used in an amount of 0 to 15 wt.-%, based on the dry layer weight, especially preferred 0.5 to 5 wt.-%.

Furthermore, the radiation-sensitive coating can comprise leuco dyes such as e.g. leuco crystal violet and leucomalachite green. They are preferably present in an amount of 0 to 10 wt.-%, based on the dry layer weight, especially preferred 0.5 to 5 wt.-%.

Additionally, the radiation-sensitive coating can comprise surfactants (flow improvers). Suitable surfactants include siloxane-containing polymers, fluorine-containing polymers and polymers with ethylene oxide and/or propylene oxide groups. They are preferably present in an amount of 0 to 10 wt.-%, based on the dry layer weight, especially preferred 0.2 to 5 wt.-%.

Exposure indicators, such as e.g. 4-phenylazodiphenylamine, can also be present as optional components of the radiation-sensitive coating; they are preferably present in an amount of 0 to 5 wt.-%, especially preferred 0 to 2 wt.-%, based on the dry layer weight.

### Substrates

In the production of the radiation-sensitive elements of the present invention, a dimensionally stable plate or foil-shaped material is preferably used as a substrate. Examples of such substrates include paper, paper coated with plastic materials (such as polyethylene, polypropylene, or polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred for the preparation of lithographic printing plate precursors since it shows a remarkable degree of dimensional stability, is inexpensive and furthermore exhibits excellent adhesion to the coating; furthermore, a composite film can be used wherein an aluminum foil has been laminated onto a polyethylene terephthalate film.

For lithographic printing plate precursors it is necessary that the substrate either has a naturally hydrophilic surface or is subjected to a suitable treatment generating such a surface.

A metal substrate, in particular an aluminum substrate, is preferably subjected to at least one treatment selected from graining (e.g. by brushing in a dry state or brushing with abrasive suspensions, or electrochemical graining, e.g. by means of a hydrochloric acid electrolyte), anodizing (e.g. in sulfuric acid or phosphoric acid) and hydrophilizing, especially if the radiation-sensitive element is a lithographic printing plate precursor. In order to improve the hydrophilic properties of the surface of the metal substrate that has been grained and optionally anodized in sulfuric acid or phosphoric acid, an interlayer can be provided on the metal substrate by subjecting it e.g. to an aftertreatment with an aqueous solution of sodium silicate, calcium zirconium fluoride, polyvinylphosphonic acid or phosphoric acid. Within the framework of the present invention, the term "substrate" also encompasses an optionally pretreated substrate exhibiting, for example, a hydrophilizing layer ("interlayer") on its surface.

The details of the above-mentioned substrate pre-treatment are known to the person skilled in the art.

### Production of the element

For producing an element according to the present invention, the radiation-sensitive composition is applied to the surface of the substrate by means of common coating processes (e.g. spin coating, spray coating, dip coating, coating by means of a doctor blade). It is also possible to apply the radiation-sensitive composition on both sides of the substrate; however, for the elements of the present invention, it is preferred that the radiation-sensitive coating be only applied to one side of the substrate.

Usually, the radiation-sensitive composition is applied from an organic solvent or solvent mixture.

Suitable solvents include low alcohols (e.g. methanol, ethanol, propanol and butanol), glycolether derivatives (e.g. ethylene glycol monomethylether, ethylene glycol dimethylether, propylene glycol monomethylether, ethylene glycol monomethylether acetate, ethylene glycol monoethylether acetate, propylene glycol monomethylether acetate, propylene glycol monoethylether acetate, ethylene glycol monoisopropylether acetate, ethylene glycol monobutylether acetate, diethylene glycol monomethylether, diethylene glycol monoethylether), ketones (e.g. diacetone alcohol, acetyl acetone, acetone, methyl ethyl ketone, cyclohexanone, methyl isobutyl ketone), esters (e.g. methyl lactate, ethyl lactate, ethyl acetate, 3-methoxypropyl acetate and butyl acetate), aromatics (e.g. toluene and xylene), cyclohexane, 3-methoxy-2-propanol, 1-methoxy-2-propanol, methoxymethoxyethanol, γ-butyrolactone and dipolar aprotic solvents (e.g. THF, dimethylsulfoxide, dimethylformamide and N-methyl-propyrrolidone) and mixtures thereof. The solids content of the radiation-sensitive mixture to be applied depends on the coating method that is used and is preferably 1 to 50 wt.%.

The dry layer weight of the radiation-sensitive layer is preferably 0.5 to 4 g/m², more preferably 0.8 to 3 g/m².

The additional application of a water-soluble oxygen-impermeable overcoat onto the radiation-sensitive layer can be advantageous. The polymers suitable for such an overcoat include, *inter alia,* polyvinyl alcohol, polyvinyl alcohol/polyvinyl acetate copolymers, polyvinyl pyrrolidone, polyvinyl pyrrolidone/polyvinyl acetate copolymers, polyvinyl methylethers, decyclized copolymers of maleic acid anhydride and a comonomer such as methylvinylether, polyacrylic acid, cellulose ether, gelatin, etc.; polyvinyl alcohol is preferred. Preferably, the composition for the oxygen-impermeable overcoat is applied in the form of a solution in water or in a solvent miscible with water; in any case, the solvent is selected such that the radiation-sensitive coating already present on the substrate essentially does not dissolve upon application of the overcoat composition. The layer weight of the overcoat can e.g. be 0.1 to 6 g/m², preferably 0.5 to 4 g/m². However, the printing plate precursors according to the present invention show excellent properties even without an overcoat. The overcoat can also comprise matting agents (i.e. organic or inorganic particles with a particle size of 2 to 20 µm) which facilitate the planar positioning of the film during contact exposure. In order to improve adhesion of the overcoat to the radiation-sensitive layer, the overcoat can comprise adhesion promoters such as e.g. poly(vinylpyrrolidone), poly(ethyleneimine) and poly(vinylimidazole). Suitable overcoats are described for example in WO 99/06890.

### Imaging

The thus produced radiation-sensitive elements are image-wise exposed in a manner known to the person skilled in the art with radiation of a wavelength of >300 nm (preferably >300 to 480 nm, more preferably 350 to 450 nm). Metal halide-doped Hg lamps can for example be used as a radiation source. Violet laser diodes emitting UV radiation in the range of about 405 nm (e.g. 405 ±10 nm) are of particular interest as a radiation source. In addition to ns- and ps-lasers, fs-lasers can be used as well for imaging the lithographic printing plate precursors of the present invention since the sensitizers used in the present invention are capable of simultaneous two-photon excitation. As a rule, fs-lasers provide pulses with a pulse width of <200 fs, a frequency of >70 MHz and an emission wavelength in the range of 710 to 950 nm. The multi-photon-initiated polymerization has the advantage that a higher resolution can be achieved compared to the one-photon process.

After image-wise exposure, a heat treatment can be optionally carried out at 50 to 180°C, preferably 90 to 150°C.

The imagewise exposed and optionally heat treated element is contacted with an aqueous alkaline developer by rubbing or wiping the imageable layer with an applicator containing the developer. Alternatively, the exposed precursor may be brushed with the developer or the developer may be applied to the precursor by spraying. The treatment with the developer can also be carried out by immersing the exposed element in a bath of the developer. Preferably, the processing may be carried out in a commercially available processor which contains a developer bath, washing section, gumming section and a drying section. Additionally, a conductivity-measuring unit can be incorporated into the processor. By treating the exposed element with the developer the non-image areas (i.e. non-exposed areas) of the coating are removed.

The exposed element is typically treated with the developer at a temperature of 18°C to about 28°C, for a period of about 5 seconds to about 60 seconds.

After a certain number of exposed elements have been processed, the developing activity (for instance determined by titration or conductivity measurement) of the developer falls below a predetermined level. Then fresh developer is added to the processing bath (also called "top-up" process). Usually about 30 mL to about 100 mL, typically about 50-80 mL, of fresh developer per 1 m² of element processed is necessary to keep both the volume of developer and its activity/conductivity value constant.

Instead of adding fresh developer for keeping the activity of the developer bath constant a replenisher can be added. The replenisher suitably differs from the fresh developer in that the concentration of the alkaline reagent is higher compared to the concentration of the alkaline reagent in the fresh developer used; the concentration of the other components might be the same or higher as in the fresh developer.

The processed element like a lithographic printing plate comprises regions in which imageable layer has been removed revealing the underlying surface of the substrate, and complimentary regions in which the imageable layer has not been removed.

In the case of lithographic printing plates the developed elements can be treated with a preservative ("gumming") using a common method. The preservatives are aqueous solutions of hydrophilic polymers, wetting agents and other additives.

For certain applications (e.g. in the case of printing plates), it is furthermore advantageous to increase the mechanical strength of the portions of the coating remaining after developing by subjecting them to a heat treatment (what is referred as "baking") and/or a combination of baking and overall exposure (e.g. to UV light). For this purpose, prior to the treatment, the developed element is treated with a solution that protects the non-image areas such that the heat treatment does not cause these areas to accept ink. A solution suitable for this purpose is e.g. described in US-A-4,355,096. Baking takes place at a temperature in the range of 150 to 250°C. However, elements such as printing plates prepared from radiation-sensitive elements according to the present invention show excellent properties even without having been subjected to a heat treatment. When both baking and overall exposure are carried out, the two treatment steps can be performed simultaneously or one after the other.

### Advantages

The radiation-sensitive elements according to the present invention are characterized by excellent stability under yellow light conditions, an excellent photosensitivity and excellent storage stability. In the case of printing plate precursors, the developed printing plates exhibit excellent abrasion resistance which allows a high print run length. These advantages are achieved by the use of the unique substituted triarylamine sensitizers of formula (I) in combination with the "reactive binders" described above.

The invention will be explained in more detail in the following examples; however, they shall not restrict the invention in any way.

### Examples

### Examples 1 to 44 and Comparative Examples 1 to 5

An electrochemically grained (in HCl) and anodized aluminum foil was subjected to a treatment with an aqueous solution of polyvinylphosphonic acid (PVPA) and, after drying, coated with a solution as described in Table 1 and dried.

**Table 1**

| Component | Amount (g) |
|---|---|
| propylene glycol monomethyl ether | 9 |
| methanol | 6 |
| butanone | 7.25 |
| reactive binder shown in Table 2 | 1.62 |
| dispersion in propylene glycol mono methyl ether containing 7.25 wt% of copper phthalocyanine and 7.25 wt% of a polyvinylacetal binder containing 39.9 mol% vinyl alcohol groups, 1.2 mol% vinylacetate groups, 15.4 mol% acetal groups derived from acetaldehyde, 36.1 mol% acetal groups derived from butyraldehyde and 7.4 acetal groups derived from 4-formylbenzoic acid | 0.28 |
| Kayamer PM-2 (ester of 1 mol phosphoric acid and 1.5 mol hydroxyethylmethacrylate) | 0.02 |
| 80% methyl ethyl ketone solution of an urethane acrylate prepared by reacting Desmodur N 100® (available from BAYER, Germany) with hydroxy ethyl acrylate and pentaerythritol triacrylate; amount of double bonds: 0.5 double bonds per 100 g when all isocyanate groups have completely reacted with the acrylates containing hydroxy groups | 2.745 |
| NK Ester PBE 500 * | 0.15 |
| sensitizer (see Table 3) | Concentration was adjusted in such a way that the OD at 405 nm was 0.4; in the examples the required amount was between 0,1 and 0,5 g |
| coinitiator (see Table 3) | y |
| mercapto-triazol | 0.124 |

| | |
|---|---|
| *) ethoxylated bisphenol A dimethacrylate (approximately 10 ethylene oxide units), available from Shin Nakamura Ltd. | |

**Table 2**

| reactive binders | M_{A} | M_{B} | M_{C} | M_{A}/ M_{B} / M_{C} (mol%) | A/B/C (wt%) | acid number (mg KOH/g) found |
|---|---|---|---|---|---|---|
| Comparative P1 | methacrylic acid | - | methyl methacrylate | 13/-/87 | 11/-/89 | 70 |
| P1 | methacrylic acid | allyl methacrylate | methyl methacrylate | 10/70/20 | 7/76/ 17 | 46 |
| P2 | ethylene-glycole methacrylate phosphate | allyl methacrylate | methyl methacrylate | 5/65/30 | 14/63/23 | 27 |
| P3 | methacrylic acid | allyl methacrylate | methacrylamide | 10/70/20 | 7/76/17 | 51 |
| P4 | methacrylic acid | allyl methacrylate | methyl methacrylate | 5/75/20 | 4/80/17 | 23 |
| P5 | methacrylic acid | allyl methacrylate | polypropylene-glycole methacrylate | 10/86/4 | 6/81/12 | 41 |
| P6 | methacrylic acid | allyl methacrylate | N-ethylacrylamide | 10/70/20 | 7/74/19 | 46 |
| P7 | methacrylic acid | allyl methacrylate | styrene | 10/80/10 | 7/84/9 | 45 |
| P8 | methacrylic acid | allyl methacrylate | styrene | 20/60/20 | 15/67/18 | 85 |
| P9 | methacrylic acid | allyl methacrylate | n-isopropylacrylamide | 15/65/20 | 6/83/12 | 42 |
| P10 | methacrylic acid | allyl methacrylate | styrene | 25/50/25 | 19/57/24 | 119 |
| P11 | methacrylic acid | allyl methacrylate | n-isopropylacrylamide | 10/70/20 | 7/72/21 | 48 |
| P12 | methacrylic acid | allyl methacrylate | n-isopropylacrylamide | 10/60/30 | 7/62/31 | 49 |
| P13 | methacrylic acid | glycidyl methacrylate, finally esterified at the glycidyl group with methacrylic acid | methyl methacrylate | 20/50/30 | 12/68/21 | 79 |
| P14 | methacrylic acid | allyl methacrylate | 1,1,1-trifluoro-ethyl methacrylate | 10/70/20 | 7/68/26 | 42 |
| P15 | methacrylic acid | allyl methacrylate | 1,1,1-trifluoro-ethyl methacrylate | 15/70/15 | 10/70/20 | 64 |
| P16 | methacrylic acid | allyl methacrylate | 1,1,1-trifluoro-ethyl methacrylate | 20/70/10 | 14/72/14 | 87 |

The solution was filtered, applied to the lithographic substrate and the coating was dried for 4 minutes at 90°C. The dry layer weight of the photopolymer layer was about 1.5 g/m².

The obtained samples were coated with an overcoat by applying an aqueous solution of poly(vinylalcohol) (Airvol 203 available from Airproducts; degree of hydrolysis: 88%); after drying for 4 minutes at 90°C, the overcoat had a dry layer weight of about 3 g/m².

The printing plate precursor was image-wise exposed with an image-setter Andromeda® A750M from Lithotech, equipped with a laser diode (405 nm; P = 30 mW; cw). For this purpose, a UGRA gray scale V2.4 with defined tonal values was used. Additionally, the sensitivity of the plate was determined using an UGRA offset test strip 1982 under overall exposure.

Immediately after exposure, the plate was heated in an oven for 2 minutes at 90°C.

Then, the exposed and thermally treated plate was treated for 30 seconds with an aqueous developer solution containing 5 wt.% poly(ethylene glycol)-2-naphthylether and KOH as alkaline component in such an amount that the pH was 12.

Then the developer solution was again rubbed over the surface for another 30 seconds using a tampon and then the entire plate was rinsed with water. After this treatment, the exposed portions remained on the plate. For the assessment of its photosensitivity, the plate was blackened in a wet state with printing ink.

For the assessment of the storage stability of the plates, the unexposed printing plate precursors were stored for 60 minutes in a 90°C oven, then exposed and developed as described above (storage stability test).

For the preparation of a lithographic printing plate, a printing layer was applied to the aluminum foil as explained above, exposed, heated, developed, and after rinsing with water, the developed plate was rubbed and gummed with an aqueous solution of 0.5% phosphoric acid and 6% gum arabic. The thus prepared plate was loaded in a sheet-fed offset printing machine and used for printing with an abrasive printing ink (Offset S 7184® available from Sun Chemical, containing 10% potassium carbonate). The results are summarized in Table 3.

The results in Table 3 show that by using a sensitizer of formula (I) in combination with a reactive binder, printing plates showing high photospeed, good storage stability and good press durability can be obtained. Furthermore, it can be derived from the comparison of Examples 2 and 44 that a preheat step is not required if a somewhat less sensitivity is acceptable.

**Table 3**

| Example | type of sensitizer ⁰⁾ | type of co-initiator | amount of co-initiator in g | reactive binder (Table 2) | energy for image creation at 405nm¹⁾ (µJ/cm²⁾ | energy for image creation at 405nm¹⁾ 60 min /90°C²⁾ (µJ/cm²⁾ | press durability |
|---|---|---|---|---|---|---|---|
| Comparative 1 | **S2** | o-Cl-Habi³⁾ | 0.175 | Comparative P1 | 60 | 65 | visible wear after 75000 copies |
| Comparative 2 (EP 1349006) | 1,4-Distyryl-3,4,5-trimethoxybenzene⁴⁾ | o-Cl-Habi³⁾ | 0.175 | P6 | 190 | 280 | visible wear after 15000 copies |
| Comparative 3 (EP 1445120) | 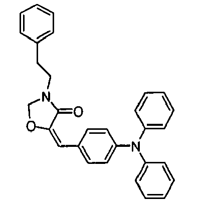 | o-Cl-Habi³⁾ | 0.175 | P6 | 280 | >>400 | visible wear after 25000 copies |
| Comparative 4 (JP2002221790) | 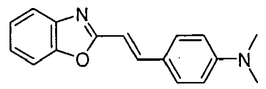 | o-Cl-Habi³⁾ | 0.175 | P6 | No image | No image | |
| Comparative 5 (JP2002221790) | 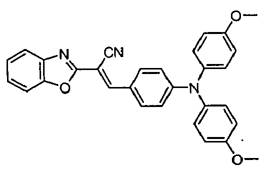 | o-Cl-Habi³⁾ | 0.175 | P6 | >>400, sensitivity too slow | No image | |
| 1 | **S1** | o-Cl-Habi³⁾ | 0.175 | P6 | 40 | 50 | until 100 000 copies no wear |
| 2 | **S2** | o-Cl-Habi³⁾ | 0.175 | P6 | 30 | 30 | until 100 000 copies no wear |
| 3 | **S2** | o-Cl-Habi³⁾ | 0.175 | P1 | 40 | 45 | until 100 000 copies no wear |
| 4 | **S2** | o-Cl-Habi³⁾ | 0.175 | P2 | 35 | 40 | until 100 000 copies no wear |
| 5 | **S2** | o-Cl-Habi³⁾ | 0.175 | P3 | 45 | 45 | until 100 000 copies no wear |
| 6 | **S2** | o-Cl-Habi³⁾ | 0.175 | P4 | 30 | 35 | until 100 000 copies no wear |
| 7 | **S2** | o-Cl-Habi³⁾ | 0.175 | P5 | 30 | 40 | until 100 000 copies no wear |
| 8 | **S2** | o-Cl-Habi³⁾ | 0.175 | P7 | 40 | 45 | until 100 000 copies no wear |
| 9 | **S2** | o-Cl-Habi³⁾ | 0.175 | P8 | 45 | 45 | until 100 000 copies no wear |
| 10 | **S2** | o-Cl-Habi³⁾ | 0.175 | P9 | 35 | 40 | until 100 000 copies no wear |
| 11 | **S2** | o-Cl-Habi³⁾ | 0.175 | P10 | 45 | 45 | until 100 000 copies no wear |
| 12 | **S2** | o-Cl-Habi³⁾ | 0.175 | P11 | 40 | 30 | until 100 000 copies no wear |
| 13 | **S2** | o-Cl-Habi³⁾ | 0.175 | P12 | 30 | 30 | until 100 000 copies no wear |
| 14 | **S2** | o-Cl-Habi³⁾ | 0.175 | P13 | 30 | 30 | until 100 000 copies no wear |
| 15 | **S2** | o-Cl-Habi³⁾ | 0.175 | P14 | 45 | 45 | until 100 000 copies no wear |
| 16 | **S2** | o-Cl-Habi³⁾ | 0.175 | P15 | 40 | 40 | until 100 000 copies no wear |
| 17 | **S2** | o-Cl-Habi³⁾ | 0.175 | P16 | 35 | 40 | until 100 000 copies no wear |
| 18 | **S3** | o-Cl-Habi³⁾ | 0.175 | P6 | 55 | 55 | until 100 000 copies no wear |
| 19 | **S4** | o-Cl-Habi³⁾ | 0.175 | P6 | 35 | 40 | until 100 000 copies no wear |
| 20 | **S5** | o-Cl-Habi³⁾ | 0.175 | P6 | 45 | 50 | until 100 000 copies no wear |
| 21 | **S6** | o-Cl-Habi³⁾ | 0.175 | P6 | 40 | 45 | until 100 000 copies no wear |
| 22 | **S7** | o-Cl-Habi³⁾ | 0.175 | P6 | 35 | 40 | until 100 000 copies no wear |
| 23 | **S8** | o-Cl-Habi³⁾ | 0.175 | P6 | 45 | 45 | until 100 000 copies no wear |
| 24 | **S9** | o-Cl-Habi³⁾ | 0.175 | P6 | 40 | 40 | until 100 000 copies no wear |
| 25 | **S10** | o-Cl-Habi³⁾ | 0.175 | P6 | 40 | 40 | until 100 000 copies no wear |
| 26 | **S11** | o-Cl-Habi³⁾ | 0.175 | P6 | 45 | 45 | until 100 000 copies no wear |
| 27 | **S12** | o-Cl-Habi³⁾ | 0.175 | P6 | 45 | 50 | until 100 000 copies no wear |
| 28 | **S13** | o-Cl-Habi³⁾ | 0.175 | P6 | 40 | 45 | until 100 000 copies no wear |
| 28 | **S14** | o-Cl-Habi³⁾ | 0.175 | P6 | 40 | 40 | until 100 000 copies no wear |
| 30 | **S15** | o-Cl-Habi³⁾ | 0.175 | P6 | 35 | 40 | until 100 000 copies no wear |
| 31 | **S16** | o-Cl-Habi³⁾ | 0.175 | P6 | 35 | 45 | until 100 000 copies no wear |
| 32 | **S17** | o-Cl-Habi³⁾ | 0.175 | P6 | 40 | 40 | until 100 000 copies no wear |
| 33 | **S1** | iodonium salt 1⁴⁾ | 0.25 | P6 | 55 | 55 | until 100 000 copies no wear |
| 34 | **S2** | iodonium salt 1⁴⁾ | 0.25 | P6 | 55 | 60 | until 100 000 copies no wear |
| 35 | **S9** | iodonium salt 1⁴⁾ | 0.25 | P6 | 40 | 50 | until 100 000 copies no wear |
| 36 | **S10** | iodonium salt 1⁴⁾ | 0.25 | P6 | 50 | 55 | until 100 000 copies no wear |
| 37 | **S11** | iodonium salt 1⁴⁾ | 0.25 | P6 | 65 | 65 | until 100 000 copies no wear |
| 38 | **S12** | iodonium salt 1⁴⁾ | 0.25 | P6 | 55 | 55 | until 100 000 copies no wear |
| 39 | **S13** | iodonium salt 1⁴⁾ | 0.25 | P6 | 55 | 55 | until 100 000 copies no wear |
| 40 | **S14** | iodonium salt 1⁴⁾ | 0.25 | P6 | 50 | 55 | until 100 000 copies no wear |
| 43 | **S2** | alkoxy pyridinium salt 1⁵⁾ | 0.25 | P6 | 65 | 65 | until 100 000 copies no wear |
| 44⁶⁾ | **S2** | o-Cl-Habi³⁾ | 0.175 | P6 | 100 | 100 | until 100 000 copies no wear |

| | | | | | | | |
|---|---|---|---|---|---|---|---|
| 0) The designations S1-S17 refer to the structures S1-S17 shown above 1) Energy required to obtain one step of an UGRA gray scale on a fresh plate 2) Storage stability test: Energy required to obtain one step of an UGRA gray scale on a plate that has been stored for 60 minutes at 90°C 3) 2,2-Bis-(2-chlorophenyl)-4,5,4',5'-tetraphenyl-2'H-[1,2']biimidazolyl 4) Diphenyl iodonium chloride 5) 4-Phenyl-1-methoxypyridinium 6) This example differs from example 2 in that no preheat was applied. | | | | | | | |

### Examples 45 to 54 and Comparative Examples 6 to 8

Yellow light stability is a further important factor with respect to lithographic printing plate precursors which are imaged with wavelengths of about 400 nm; therefore, different plate precursors were examined for their yellow light stability.

Precursors with the coatings specified in Table 4 were exposed under defined yellow light conditions (yellow light tube L36W/62 from Osram) to overall exposure with an intensity of 1860 lux at intervals of 0.5, 1, 5, 10, 20 and 30 min; immediately thereafter, they were heated to 90°C in an oven for two minutes and developed as described in Example 1. Then the optical density was determined with a densitometer (XRITE Spectrodensitometer) and plotted against the yellow light energy in lux•min. The optical density of the substrate was 0.28; an increase in the optical density signifies pre-damage to the plate (partial exposure) since after developing there are still coating residues in the non-image areas. Such a pre-damaged plate is no longer usable for printing since it can lead to toning in the printing machine. In order to be able to judge the yellow light stability, the exposure necessary to damage the plate was measured; basically, a higher the yellow light energy means higher yellow light stability. The results can be inferred from Table 4; in addition, the results of Example 45 and Comparative Example 6 are graphically illustrated in Fig. 1.

**Table 4**

| Example | Added amount of titanocene ⁶⁾ | Coating | Necessary energy to pre-damage the plate (lux-min) |
|---|---|---|---|
| 45 | 0 | as in Example 2 | > 60000, no pre-damage observed, experiment was disconnected |
| 46 | 0 | as in Example 25 | > 60000, no pre-damage observed, experiment was disconnected |
| 47 | 0 | as in Example 26 | > 60000, no pre-damage observed, experiment was disconnected |
| 48 | 0 | as in Example 27 | > 60000, no pre-damage observed, experiment was disconnected |
| 49 | 0 | as in Example 28 | > 60000, no pre-damage observed, experiment was disconnected |
| 50 | 0 | as in Example 29 | > 60000, no pre-damage observed, experiment was disconnected |
| 51 | 0 | as in Example 30 | > 60000, no pre-damage observed, experiment was disconnected |
| 52 | 0 | as in Example 31 | > 60000, no pre-damage observed, experiment was disconnected |
| 53 | 0 | as in Example 32 | > 60000, no pre-damage observed, experiment was disconnected |
| 54 | 0 | as in Example 33 | > 60000, no pre-damage observed, experiment was disconnected |
| Comparative 6 | 0.15 | as in Example 2 but with titanocene instead of o-Cl-Habi³⁾ | > 930 but less than 1860 |
| Comparative 7 | 0.15 | as in Comparative Example 2 but with titanocene instead of o-Cl-Habi³⁾ | > 930 but less than 1860 |
| Comparative 8 | 0.25; lower photospeed if less amount of CGI 784⁷⁾ is used | as in Comparative Example 3 but with titanocene instead of o-Cl-Habi³⁾ | > 930 but less than 1860 |

| | | | |
|---|---|---|---|
| 7) CGI 584 is bis (η)-5-2,4-cyclopentadien-1-yl)-bis-(2,6-difluoro-3-(1H-pyrrol-1-yl)phenyl)-titanium; available from CIBA | | | |

## Claims

1. UV-sensitive element comprising
(1) a substrate and
(2) a radiation-sensitive coating comprising
(a) one or more types of monomers and/or oligomers, each comprising at least one ethylenically unsaturated group accessible to a free-radical polymerization,
(b) at least one sensitizer,
(c) at least one coinitiator capable of forming free radicals together with the sensitizer (b), said coinitiator being other than metallocenes,
(d) at least one reactive polymeric binder comprising
(i) structural units (m1) comprising at least one pendant acidic group,
(ii) structural units (m2) comprising at least one pendant free radical polymerizable group, and
(iii) optionally further structural units (m3) different from units (m1) and (m2)
and
(e) optionally one or more components selected from the group consisting of alkali-soluble non-reactive binders, colorants, exposure indicators, plasticizers, chain transfer agents, leuco dyes, surfactants, inorganic fillers and thermopolymerization inhibitors,
**characterized in that** the at least one sensitizer (b) comprises a compound of formula (I) 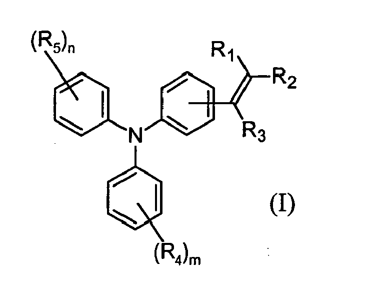 wherein
R₁ is an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl,-O-aryl, -S-aryl, -O-acyl, -S-acyl, halogen, cyano, substituted boron, -COOR and -CSOR;
R₂ is selected from optionally substituted alkyl, aryl, aralkyl, alkylaryl, -N(alkyl)₂,-N(aryl)₂, -N(alkyl)(aryl), -O-alkyl, -S-alkyl, -O-aryl, -S-aryl, -O-acyl, -S-acyl, halogen, cyano, substituted boron, -COOR, -CSOR, an aryl which is substituted by one to five substituents independently selected from alkyl, aryl, aralkyl, alkylaryl, -N(alkyl)₂, - N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₃ is selected from hydrogen, optionally substituted alkyl, aryl, aralkyl, alkylaryl,-N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to five substituents independently selected from alkyl, aryl, aralkyl, alkylaryl,-N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₄ and R₅ are independently selected from -CR₃=CR₁R₂ with R₁, R₂ and R₃ being as defined above, optionally substituted alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -CH₂-O-R, -CH₂-S-R, -COOR and -CSOR;
if there are two adjacent substituents R₄ they can optionally form a fused aromatic or non-aromatic carbocyclic ring; the same applies to R₅;
each R is independently selected from optionally substituted alkyl, optionally substituted aryl, aralkyl and alkylaryl;
m and n are the same or different and are integers from 0 to 5.

2. Element according to claim 1 or 2, wherein R₄ and R₅ are independently selected from -CH₃, -OCH₃, F, -CH=C(phenyl)₂.

3. Element according to any of claims 1 to 3, wherein R₁ and R₂ are independently selected from substituted and unsubstituted phenyl, -phenylene-N(alkyl)₂, -phenylene-N(aryl)₂.

4. Element according to any of claims 1 to 3, wherein the sensitizer comprises a compound selected from S1 - S17:

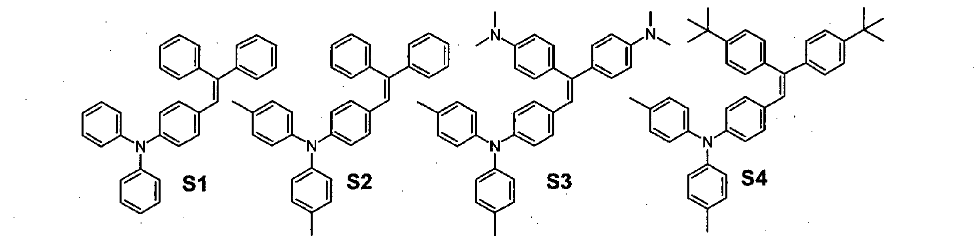

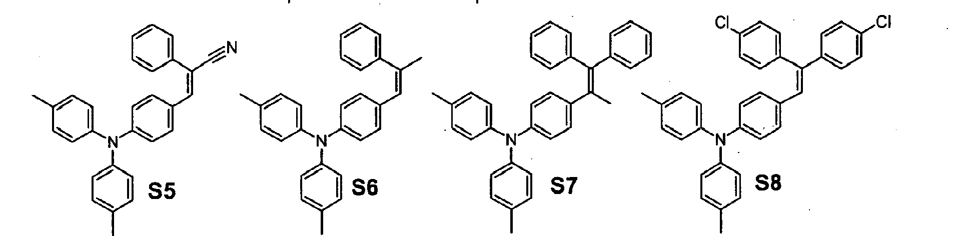

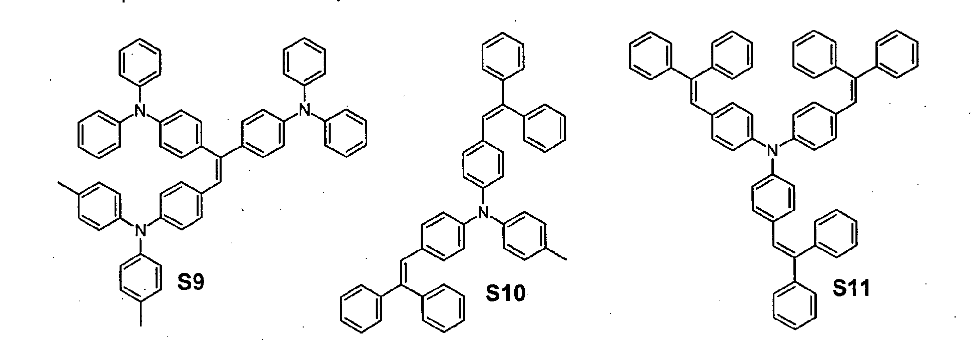

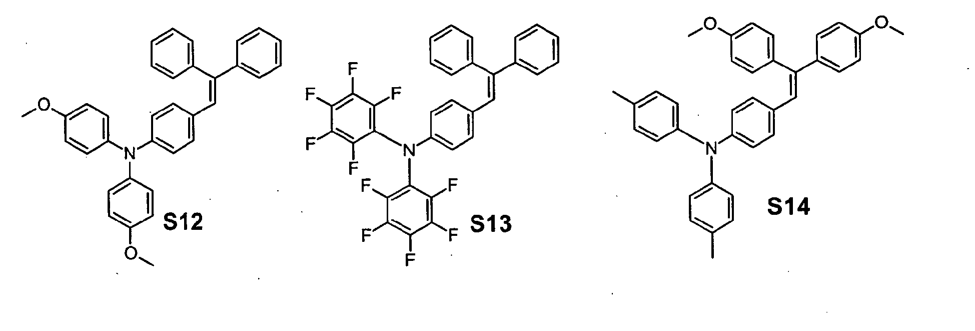

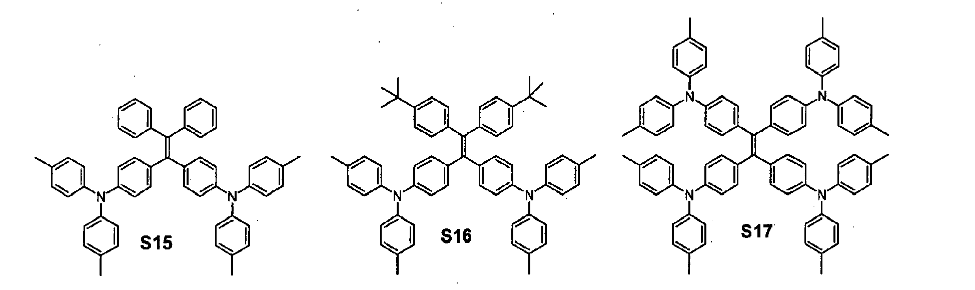

5. Element according to any of claims 1 to 5, wherein the coinitiator (iii) is selected from hexaarylbiimidazoles, onium salts, thiol compounds, and mixtures thereof.

6. Element according to any of claims 1 to 6, wherein the substrate is an aluminum foil or plate which was optionally subjected to at least one treatment selected from graining, anodizing and hydrophilizing prior to coating.

7. Element according to any of claims 1 to 8, wherein the element furthermore comprises an oxygen-impermeable overcoat.

8. Process for imaging an element according to any of claims 1 to 7 comprising
(a) image-wise exposure of an element as defined in any of claims 1 to 7 to UV radiation of >300 nm;
(b) optionally heating the exposed element obtained in step (a),
(c) removing the non-exposed areas of the coating by means of an aqueous alkaline developer, and
(d) optionally subjecting the developed element obtained in step (c) to at least one treatment selected from heating and overall exposure.

9. Imaged element obtainable by the process of claim 8.

10. Radiation-sensitive composition comprising
(a) one or more types of monomers and/or oligomers, each comprising at least one ethylenically unsaturated group accessible to a free-radical polymerization,
(b) at least one sensitizer,
(c) at least one coinitiator capable of forming free radicals together with the sensitizer (b), said coinitiator being other than metallocenes, and
(d) at least one reactive polymeric binder comprising
(i) structural units (m1) comprising at least one pendant acidic group,
(ii) structural units (m2) comprising at least one pendant free radical polymerizable group, and
(iii) optionally further structural units (m3) different from units (m1) and (m2)
(e) optionally one or more components selected from the group consisting of alkali-soluble non-reactive binders, colorants, exposure indicators, plasticizers, chain transfer agents, leuco dyes, surfactants, inorganic fillers and thermopolymerization inhibitors,
(f) at least one solvent,
**characterized in that** the sensitizer comprises at least one compound of formula (I): 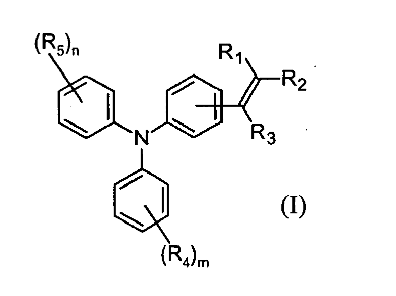 wherein
R₁ is an aryl which is substituted by one to five substituents independently selected from alkyl, aryl, aralkyl, alkylaryl, -N(alkyl)₂, -N(aryl)₂, -N(alkyl)(aryl), -O-alkyl, -S-alkyl,-O-aryl, -S-aryl, -O-acyl, -S-acyl, halogen, cyano, substituted boron, -COOR and -CSOR;
R₂ is selected from optionally substituted alkyl, aryl, aralkyl, alkylaryl, -N(alkyl)₂,-N(aryl)₂, -N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to five substituents independently selected from alkyl, aryl, aralkyl, alkylaryl, -N(alkyl)₂,-N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₃ is selected from hydrogen, optionally substituted alkyl, aryl, aralkyl, alkylaryl,-N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR, -CSOR, and an aryl which is substituted by one to fivesubstituents independently selected from alkyl, aryl, aralkyl, alkylaryl,-N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron, -COOR and -CSOR;
R₄ and R₅ are independently selected from -CR₃=CR₁R₂ with R₁, R₂ and R₃ being as defined above, optionally substituted alkyl, aryl, aralkyl, alkylaryl, -N(alkyl)₂, -N(aryl)₂, -N(alkyl)(aryl), -O-alkyl, -S-alkyl, -O-aryl, -S-aryl, -O-acyl, -S-acyl, halogen, cyano, substituted boron; -CH₂-O-R, -CH₂-S-R, -COOR and -CSOR;
if there are two adjacent substituents R₄ they can optionally form a fused aromatic or non-aromatic carbocyclic ring; the same applies to R₅;
each R is independently selected from optionally substituted alkyl, optionally substituted aryl, aralkyl and alkylaryl;
m and n are the same or different and are integers from 0 to 5.

11. Use of the radiation-sensitive composition as defined in claim 10 for the preparation of an imageable UV-sensitive element.
